# EUROPEAN PATENT APPLICATION

(11) **EP 2 138 854 A1**
(43) Date of publication of application: **30.12.2009**
(21) Application number: 09163364.4
(22) Date of filing: 22.06.2009
(51) Int. Cl.: G01R 27/02, G01R 31/00, G01R 31/02

(54) **Apparatus and method of determining insulation resistance in an ungrounded mobile vehicle electrical bus system**

(30) Priority: 26.06.2008 US 147319
(71) Applicant: Deere & Company, Moline, IL 61265-8098 (US)
(72) Inventor: Shoemaker, Jim M, Bettendorf, IA 52722 (US); Penfold, Garn F, East Moline, IL 61244 (US); Stahlhut, Ronnie D, Bettendorf, IA 52722 (US)
(74) Representative: Holst, Sönke

(57) **Abstract**

An insulation resistance detection system for use with a vehicle having a chassis. The system includes an electrical power source, an electrical system, and a detection circuit. The electrical system is electrically isolated from the chassis. The detection circuit is powered by the power source. The detection circuit includes a resistor electrically connected to the chassis. The detection circuit measures the voltage across the resistor to thereby determine insulation resistance between the electrical system and the chassis.

## Description

The present invention relates to electrical systems for vehicles, and, more particularly, to vehicles having a chassis and an isolated electrical system.

A vehicle such as a work machine in the form of a construction work machine, an agricultural work machine or a forestry work machine, typically includes a power unit in the form of an internal combustion (IC) engine. The IC engine may either be in the form of a compression ignition engine, such as a diesel engine, or a spark ignition engine, such as a gasoline engine.

An isolated high voltage electrical system may operate in conjunction with a typical vehicle power generation system yet be electrically isolated therefrom. The high voltage electrical system may have an electrical leakage path to the chassis of the vehicle. This can be undesirable particularly if both sides of the isolated electrical system begin to conduct power to the chassis.

This problem is overcome with the subject matter of claim 1. The dependent claims recite advantageous features of embodiments of the invention.

The invention is directed to an insulation resistance detection system for use with a vehicle having a chassis. The system includes an electrical power source, an electrical system, and a detection circuit. The electrical system is electrically isolated from the chassis. The detection circuit is powered by the power source. The detection circuit includes a resistor electrically connected to the chassis. The detection circuit measures the voltage across the resistor to thereby determine the insulation resistance between the electrical system and the chassis.

The invention in another form is directed to a method of detecting an insulation resistance of an ungrounded mobile electrical system associated with a vehicle. The method includes the steps of supplying power, alternately applying two DC voltage levels, measuring an electrical value across an electrical component and determining the insulation resistance. The supplying power step supplies power to a detection circuit. The alternately applying step includes alternately applying two DC voltage levels from the detection circuit through an isolation circuit to an isolated electrical system. The measuring step includes measuring an electrical value across an electrical component by the detection circuit. The electrical component is electrically connected to a chassis of the vehicle. The determining step includes determining the insulation resistance between the isolated electrical system and the chassis from information obtained in the measuring step.

An embodiment of the invention is shown in the drawings, in which:
Fig. 1 is an illustrative vehicle utilizing an embodiment of the detection system of the present invention;
Fig. 2 is a schematical rendition of circuitry illustrating the detection circuit of the present invention used with the electrical system of the vehicle of Fig. 1;
Fig. 3 is a simplified schematic diagram of the circuit of Fig. 2 in one switching mode;
Fig. 4 is another simplified schematic of the schematic of Fig. 2 in a second switching mode; and
Fig. 5 is a flow chart of an embodiment of a method of operation of the detection circuit of the present invention.

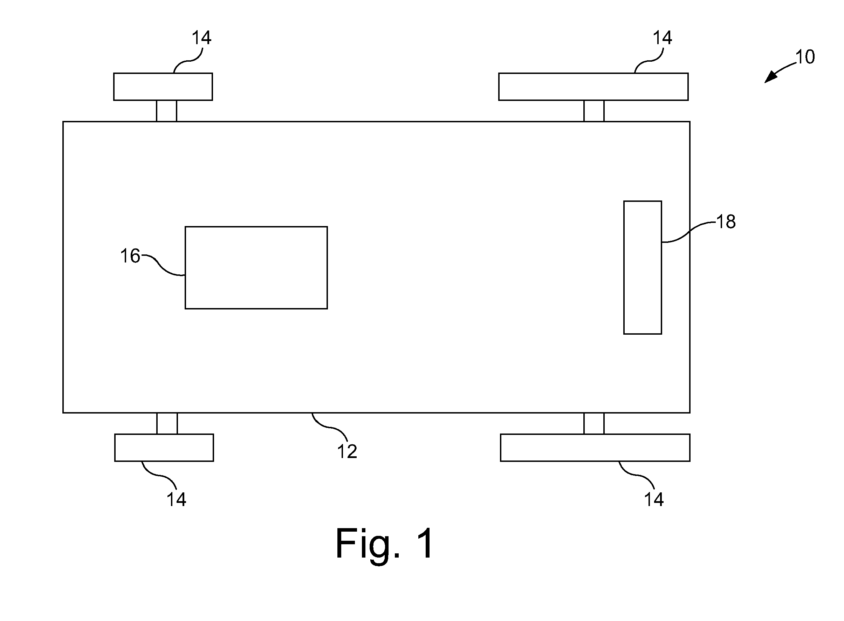

Referring now to Fig. 1, there is shown a vehicle 10 having a chassis 12 with wheels 14 attached thereto. Vehicle 10 additionally includes an engine 16 and electrical system 18. Chassis 12, which includes a frame, provides structural support for the elements of vehicle 10 also provides an electrical return for the DC power generated by a vehicular DC generation system, commonly operating at a nominal 12 volts DC. For purposes of illustration and discussion, vehicle 10 is assumed to be a work machine such as an agricultural, construction, forestry, mining, or industrial work machine. However, it is to be understood that vehicle 10 could be a different type of vehicle, such as a passenger car, truck, semi-tractor, etc. Further, it is to be understood that the vehicle may not have an engine 16, being an all electric vehicle. Or the vehicle may be powered in some other manner having a high voltage bus system as described herein.

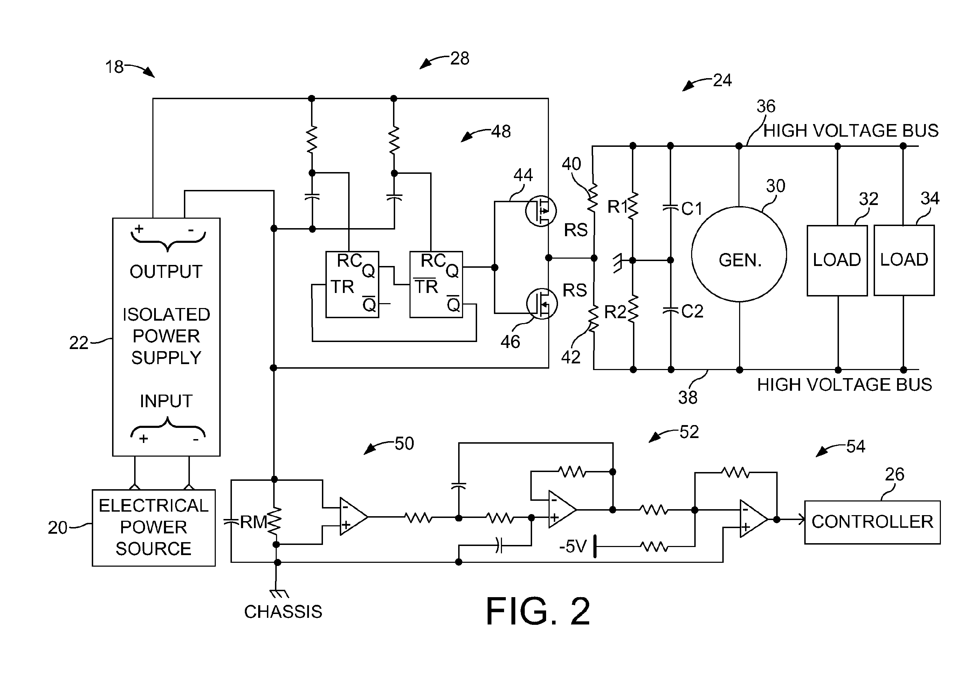

Now, additionally referring to Fig. 2, there is illustrated electrical system 18 including a vehicle electrical power source 20 operating at 12 volts, an isolated power supply 22, an isolated electrical system 24, a controller 26 and a detection circuit 28. Vehicular electrical power source 20 is a typical DC power source, which for the ease of discussion will be considered to be a 12 volt system, although other DC generation systems of different voltages may be utilized in the present invention. Isolated power supply 22 receives power from electrical power source 20 and converts it into an isolated DC output that supplies power to insulation resistance detection system 28. The isolated nature of isolated power supply 22 ensures that there are no unintentional electrical paths to the chassis ground of vehicular power source 20. Isolated power supply 22 may include an inverter circuit, a transformer and rectifier circuitry to provide the DC output of isolated power supply 22.

For the ease of illustration and discussion, isolated electrical system 24 is illustrated herein as a DC system having two electrical buses. It is recognized that the present invention is also applicable to AC bus systems and electrical systems having more than two buses. Further, the present invention will detect leakage current to the chassis that occurs from the various elements of isolated electrical system 24, such as the windings of an alternator, windings of electrical motors, inverters that may drive the electrical motors and other loads connected to the buses of isolated electrical system 24.

Isolated electrical system 24 operates at a higher electrical voltage than vehicular electrical power source 20, and may operate at 750 volts DC or some other voltage level. An advantage of a higher voltage supply system is that more power can be distributed efficiently utilizing smaller gauge wiring, thereby saving weight and cost of investment of the electrical distribution system. Isolated electrical system 24 includes a generator 30, illustrative loads 32 and 34, high voltage buses 36 and 38, with isolation resistors 40 and 42 interfacing with detection system 28. Generator 30 is driven by engine 16 either directly through a mechanical linkage or indirectly by way of intermediate system, such as a hydraulic system. For ease of discussion and illustration, generator 30 will be understood to be driven by engine 16 whether directly or indirectly. Generator 30 may include an electrical alternator and rectifying circuitry to supply a high voltage potential between bus 36 and bus 38. Loads 32 and 34 are illustrated as loads across buses 36 and 38. Loads 32 and 34 may be resistive, capacitive and/or inductive in nature, which may in some fashions alter the characteristics of electricity on buses 36 and 38. For ease of understanding, loads 32 and 34 are ignored in the discussion of insulation resistance and are there to illustrate that buses 36 and 38 supply power to loads across vehicle 10 of varying natures. Since loads 32 and 34 can also contribute to a leakage path to chassis 12 the disconnecting of these loads is discussed later herein.

Schematically illustrated are resistances R1 and R2, and capacitances C1 and C2, which are not electrical elements of isolated electrical system 24, but are illustrated to show the schematic equivalence of leakage paths that may occur between either bus 36 or bus 38 and the chassis ground. These references will be utilized to illustrate the detection of leakage from buses 36 and 38 through the chassis ground and the way in which the insulation resistance can be calculated. Ideally, equivalent resistances R1 and R2 would be infinite and equivalent capacitances C1 and C2 would be zero in a perfect operating system. The combination of R1 and C1 and the combination of R2 and C2 represent the impedance of the conduction paths between the corresponding bus and chassis 12. While isolated electrical system 24 is referred to as being isolated it is understood that leakages to chassis 12 may occur, the reference to system 24 as being isolated is to be understood as being substantially electrically isolated from chassis 12.

Detection circuit 28 includes high impedance transistors 44 and 46 that selectively provide a conductive path from the positive and negative outputs of isolated power supply 22 to the junction of resistors 40 and 42, which serve as an isolation circuit. While isolated power supply 22 has positive and negative voltage outputs, the negative output will be considered to be zero volts and the positive output is a positive voltage relative to the zero volts and may be 12 volts DC. Timing circuit 48 causes transistors 44 and 46 to be in opposite states of conduction depending upon the output of timing circuit 48. The functions of timing circuit 48 may alternatively be carried out by controller 26 in another embodiment of the present invention. Resistors 40 and 42 are, for the purposes of discussion, considered to be high resistance matched values, such as 500 kilo-ohms, but different values and unmatched resistors are also contemplated as alternate embodiments of the present invention.

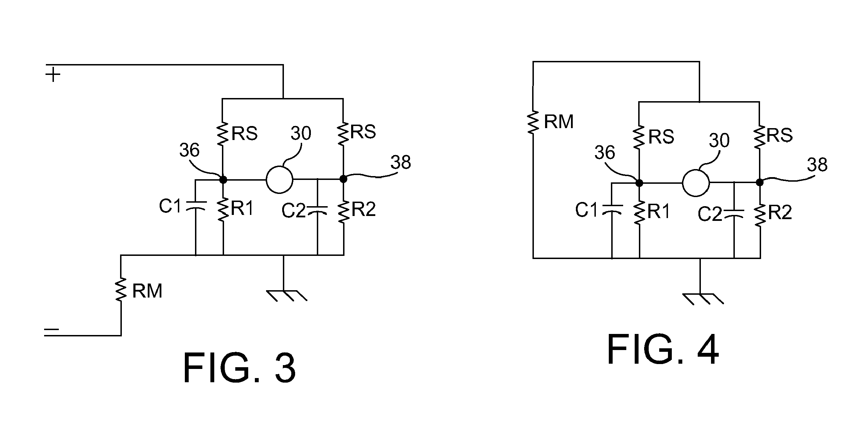

Insulation resistance detection system 28 additionally includes an instrumentation amplifier or operational amplifier 50 connected as a differential amplifier to measure the voltage across resistor RM. This measurement resistor RM is of a known value and the voltage detected thereacross is utilized to calculate the insulation resistance of isolated electrical system 24. The capacitor attached in parallel with resistor RM is used to reduce high frequency components and is ignored in the discussions surrounding Figs. 3 and 4. The output of differential amplifier 50 is passed onto a low pass filter circuit 52 that is used to pass the lower frequencies to thereby filter the output of differential amplifier 50. Shifting circuit 54 is utilized to shift the output for processing convenience. The output is sent to controller 26 for processing, which can result in an action if the insulation resistance of isolated electrical system 24 is reduced below a predetermined level. The predetermined level is selected to preclude damage to isolated electrical system 24.

Timing circuit 48, in combination with transistors 44 and 46, are configured to conduct a positive output of isolated power supply 22 to the junction of resistors 40 and 42 and then the zero volt output of isolated power supply 22 is connected to that junction when timing circuit 48 is in an opposite timing mode. For ease of understanding, the output of timing circuit 48 can be considered to be a square wave, thereby causing a square wave of the voltage levels from isolated power supply 22, consisting of the two voltage extremes, to be applied to the juncture of resistors 40 and 42. To further illustrate the results of the application of these voltages please refer to Figs. 3 and 4 where the equivalent circuitry of the switching modes is illustrated. Timing circuit 48 along with controller 26 allows for the continuous measurement of the insulation resistance of isolated electrical system 24 to be carried out in an automated manner.

In Fig. 3, transistor 44 is in a conducting mode and transistor 46 is not conducting thereby applying the plus and zero voltages from isolated power supply as shown. In the circuit of Fig. 3, if the equivalent resistances R1 and R2 are infinite and capacitances C1 and C2 are zero, then resistor RM will have no voltage thereacross to be detected by differential amplifier 50. If there is some conduction by way of the equivalent illustrated components of C1, R1, C2 and R2, then a voltage level will be detected across resistor RM, which is due to a current flow through leakage paths. The leakage from bus 36 by way of C1 and R1 and bus 38 by way of C2 and R2 each contribute to the voltage measured across resistor RM that is introduced from isolated power supply 22, along with any voltage differential created by generator 30. A voltage differential is caused by the voltage on buses 36 and 38 when, as can be generally assumed, that C1 and R1 differ from C2 and R2. In this switch mode (transistor 44 conducting and transistor 46 not conducting) the detection of a value of voltage across resistor RM is a result of the combined leakage of the insulation as well as any imbalance of the current leaking from buses 36 and 38.

In Fig. 4, timing circuit 48 switches to another mode, where transistor 44 is in a nonconductive mode and transistor 46 is in a conductive mode thereby placing the zero volt output of isolated power supply 22 at the juncture of resistors 40 and 42. This connection effectively places resistor RM as shown in Fig. 4 so that any voltage detected across resistor RM is then representative of the voltage caused by any imbalance in leakage from buses 36 and 38. The two voltage measurements across resistor RM in the two operating modes, as illustrated in Figs. 3 and 4, are used to compute two values used to determine the insulation resistance. The voltage levels measured across resistor RM can be utilized to cancel out the imbalance of leakage in isolated electrical supply 24 to allow an overall calculation of the insulation resistance of isolated electrical system 24 apart from any imbalance of a leakage of bus 36 or bus 38. This is particularly important since an imbalance in leakage of buses 36 and 38 can cause a large voltage across resistor RM, as compared to the contribution from isolated power supply 22, since isolated electrical system 24 is generally operating at a much higher voltage than isolated power supply 22.

By having the two values, which may be in the form of a digital equivalent or analog waveform, controller 26 can then calculate the insulation resistance of isolated electrical system 24. The value of the DC voltage of isolated power supply 22, the value of resistor RM, the value of resistors 40 and 42 and the operating voltage of isolated electrical system 24 all being known, the calculation of the insulation resistance using the two measured values of the voltage across RM is undertaken by controller 26.

Based on this information, of the leakage currents and the insulation resistance controller 26 can shed loads 32 and/or 34, and make further measurements to see if the leakage from bus 36 or 38 is being caused by current leakages contained in either load 32 and/or load 34. Additionally, if either the imbalance in leakage current between buses 36 and 38 is above a predetermined value or the overall insulation resistance is below another predetermined value then controller 26 can alert the operator of vehicle 10 and/or alter the operation of isolated electrical system 24 even to the extent of shutting off generator 30 of isolated electrical system 24. The steps taken can be taken to provide safety to the operator and/or prevent damage to vehicle 10.

As can be understood from Figs. 2-4, isolated electrical system 24 can be tested by the present method even if generator 30 is not functioning, since the present invention undertakes to eliminate the contribution to the leakage measurement the nonfunctioning of generator 30 does not impact the results of the measurements and calculations. The operation of the present method and the measurement of the insulation resistance can be detected as can be seen in the equivalent circuits of Fig. 3 and Fig. 4 with generator 30 simply being eliminated from the schematics.

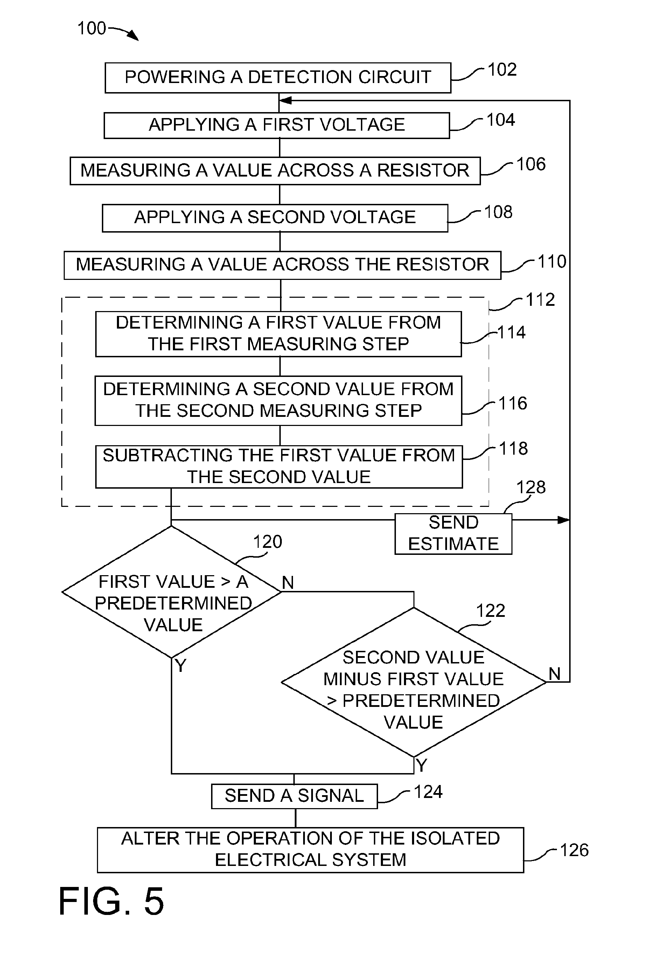

Now, additionally referring to Fig. 5, there is shown an embodiment of a method of operation 100 of the electrical system of the present invention. Although the steps of method 100 are depicted in a sequential manner, the steps may be carried out in other sequences, even without all of the steps illustrated or with other steps derived from this specification. Method 100 operates in an automated manner, with the measurements being undertaken once every full cycle of timing circuit 48. In method 100, at step 102 detection circuit 28 is powered by way of isolated power supply 22. At step 104, a first voltage level is applied by the functioning of timing circuit 48 and transistors 44 and 46 through the isolation circuit, which is a combination of resistors 40 and 42, to isolated electrical system 24. At step 106, a measurement is made of an electrical voltage across measurement resistor RM resulting in a first value. At step 108, a second voltage level is applied in a manner similar to step 104 except that the voltage level is opposite from that supplied at step 104 from isolated power supply 22. At step 110, a second value is measured across resistor RM providing a second value. Circuitry 50, 52 and 54 can be considered as conditioning the information for use by controller 26, which carries out the determining step 112 having subcomponents of determining a first value from the first measuring step 114, this first value being representative of value obtained in Fig. 4, which is indicative of an imbalance in the current leakage of buses 36 and 38. At step 116, the second value is determined from the second measuring step, which is equivalent to the circuit shown in Fig. 3, which includes the value of a leakage current that is contributed by both the imbalance as well as isolated power supply 22. At step 118, the first value is subtracted from the second value to provide the leakage current attributable to the voltage applied by isolated power supply 22. The resulting value can be used to compute the insulation resistance by utilizing the value of resistor RM, and other known values discussed above.

Regarding steps 120 and 122, the first value and the second value are considered to be leakage currents, although voltage measurements are made, the leakage currents are easily calculated since the value of RM is known. If the first value is greater than a predetermined value at step 120, method 100 proceeds to step 124. At step 122, if the second value minus the first value is greater than a predetermined value method 100 will also proceed to step 124. If both steps 120 and 122 indicate that the separate predetermined values are not exceeded then the method 100 returns to step 104 to again test the insulation resistance of isolated electrical system 24.

While what is being measured is voltage across resistor RM, controller 26 carries out the calculations to compute the insulation resistance as discussed above. At step 124, an alert is sent to the operator of a potential problem with isolated electrical system 24. Further, at step 126 method 100 can carry out an alteration in the operation of isolated electrical system 24, such as shedding loads 32 or 34, by selectively disconnecting them to determine if either of them are contributing to the leakage current measured. In addition to the automated execution of the method described herein, a technician can selectively disconnect loads 32 or 34 in a troubleshooting mode. Additionally, controller 26 may cause generator 30 to be inactivated. As previously mentioned, method 100 can be carried out whether or not generator 30 is operating so that the insulation resistance of isolated electrical system 24 can be determined even when generator 30 is not engaged by engine 16.

At step 128, controller 26 sends an estimate of the insulation resistance to the vehicle controller. The vehicle controller may use the estimate to take action and/or to record the estimates over time to thereby have historical data on the insulation resistance and to use the historical data to predict a trend in the insulation resistance. Controller 26 may send the insulation resistance estimate continually or at repeated intervals to the vehicle controller.

Within the framework of Fig. 5, another embodiment of the present invention will now be discussed that is useful in the event that there is considerable capacitance between isolated electrical system 24 and chassis 12. Considering that C1 and/or C2 are larger than the method discussed above, this method makes use of dynamic measurements conducted by detection circuit 28. The steps not separately discussed will be considered as operating in a substantially similar manner as discussed in the previous embodiment. At step 104, a first voltage level is applied by the functioning of timing circuit 48 and transistors 44 and 46 through the isolation circuit, which is a combination of resistors 40 and 42, to isolated electrical system 24. At step 106, a measurement is made of an electrical voltage across measurement resistor RM resulting in a first value. This measurement can be one measurement at a specific time after the application of the voltage at step 104, or a series of measurements taken at specifically spaced times. At step 108, a second voltage level is applied in a manner similar to step 104 except that the voltage level is opposite from that supplied at step 104 from isolated power supply 22. At step 110, a second value is measured across resistor RM providing a second value. And here again this measurement can be one measurement at a specific time after the application of the voltage at step 108, or a series of measurements taken at specifically spaced times. The measurements at steps 106 and 110 correspond in timing from the application of the corresponding voltage.

At determining step 112, the dynamic measurements taken at steps 106 and 110 are used to predict the RC curve characteristic of the leakage attributed to equivalent components R1, C1, R2 and C2, the RC curve of resistor RM and the applied voltage. The similar predictions from the two applied voltage levels are used to eliminate the effect of the leakage capacitance and to isolate the effect of resistor RM. This approach has the advantage that there is no need to wait for a period of time, such as 30 seconds, for the sensing circuit to charge the leakage capacitance C1 and/or C2, with a prediction of the insulation resistance being available in just a few seconds.

One of the terminals of each of the two bus connection resistors 40 and 42, which may each have a value of 500 kOhms, is connected to a corresponding bus that is being monitored. The second terminal of each resistor are connected together to form a first sensing node. The two resistors combine to form a parallel equivalent resistance of 250 kOhms between the first sensing node and the isolated bus.

One terminal of resistor RM, which may be a 2.5 kOhm resistor, is connected to chassis 12. The other terminal of resistor RM is connected to a second sensing node. The voltage across the resistor RM, at this sensing node, is monitored by instrumentation amplifier 50. The capacitor connected in parallel with resistor RM, may have a value of 1 µF, and reduces measurement noise.

The first terminal of the isolated power supply, which may be 12 volts, is applied to the first sensing node, and the second terminal of the isolated power supply is applied to the second sending node. Any steady state current that flows in resistor RM flows in the series combination of resistor RM, the parallel combination of resistors 40 and 42, and the leakage resistances R1 and R2 between a bus and chassis 12.

After the measurement of the steady state current that flows when the voltage is applied is acquired, then the voltage form the isolated power supply is removed and the first sensing node and the second sending node are connected together. Again the steady state current that flows in the resistor RM is measured. The two measured values of current that are so acquired are passed on for processing. The difference between the two measured currents is the current due to the applied voltage of the isolated power supply, from which the insulation resistance is calculated. The output is non-linear so the model of the bus system is used to correlate current in resistor RM to the insulation resistance of the buses.

## Claims

1. An insulation resistance detection system for use with a vehicle having a chassis, the system comprising:
an electrical power source;
an electrical system electrically isolated from the chassis; and
a detection circuit powered by said power source, said detection circuit including a resistor electrically connected to the chassis, said detection circuit measuring a voltage across said resistor to thereby determine the insulation resistance between said electrical system and the chassis.

2. The system of claim 1, further comprising an isolation circuit, said detection circuit configured to alternately apply two DC voltage levels through said isolation circuit to said electrical system

3. The system of claim 2, wherein said power source has two outputs that supply said two DC voltage levels and power said detection circuit.

4. The system of claim 2, wherein said power source is an isolated power supply, said DC voltage levels being a positive voltage and a zero voltage from said isolated power supply.

5. The system of claim 2, wherein said electrical system includes at least two electrical buses, said detection circuit being configured to detect an imbalance of leakage current from said at least two electrical buses of said electrical system to said chassis, said imbalance defining a first value.

6. The system of claim 5, wherein said detection circuit is configured to detect said imbalance of leakage current plus an other leakage current thereby defining a second value, said first value and said second value being obtained as said detection circuit alternately applies said two DC voltage levels.

7. The system of claim 6, further comprising a processing circuit that removes said first value from said second value to arrive at a value of said other leakage current, said value of said other leakage current attributed to said DC voltage levels.

8. The system of claim 7, wherein said processing circuit sends a signal indicative of at least one of an imbalance of leakage current if said first value is above a first predetermined value and a high leakage value if said second value is above a second predetermined value.

9. The system of claim 7, wherein said processing circuit alters an operational characteristic of said electrical system if one of said first value is above a first predetermined value and said second value is above a second predetermined value.

10. The system of claim 1, wherein said detection circuit is configured to determine the insulation resistance between said electrical system and the chassis without said electrical system being powered.

11. A method of detecting an insulation resistance of an ungrounded mobile electrical system associated with a vehicle, the method comprising:
supplying power to a detection circuit;
alternately applying two DC voltage levels from said detection circuit through an isolation circuit to an isolated electrical system;
measuring an electrical value across an electrical component by said detection circuit, said electrical component being electrically connected to a chassis of the vehicle; and
determining the insulation resistance between said isolated electrical system and said chassis from information obtained in said measuring step.

12. The method of claim 11, wherein said electrical component is a resistor.

13. The method of claim 11, wherein said supplying power step provides said DC voltage levels as a positive voltage and as a zero voltage from an isolated power supply.

14. The method of claim 11, wherein said measuring step is executed for each of said two DC voltage levels.

15. The method of claim 14, wherein said determining step includes the substep of determining a first value representative of an imbalance of leakage current from any of a plurality of electrical buses of said isolated electrical system to said chassis from one execution of said measuring step.
